# EUROPEAN PATENT APPLICATION

(11) **EP 2 607 403 A1**
(43) Date of publication of application: **26.06.2013**
(21) Application number: 11818258.3
(22) Date of filing: 19.08.2011
(51) Int. Cl.: C08G 77/44, H01L 23/29, H01L 23/31, H01L 33/56

(54) **PHENYL GROUP-CONTAINING ORGANIC/INORGANIC HYBRID PREPOLYMER, HEAT RESISITANT ORGANIC/INORGANIC HYBRID MATERIAL, AND ELEMENT ENCAPSULATION STRUCTURE**

(30) Priority: 20.08.2010 JP 2010184496
(71) Applicant: Nihon Yamamura Glass Co., Ltd., Hyogo 660-8580 (JP)
(72) Inventor: SHINDOU Takuya, Amagasaki-shi Hyogo 660-0857 (JP); KUBO Hidenori, Amagasaki-shi Hyogo 660-0857 (JP); SATOH Midori, Amagasaki-shi Hyogo 660-0857 (JP)
(74) Representative: Vossius & Partner
(86) International application number: PCT/JP2011/068809
(87) International publication number: WO 2012/023618

(57) **Abstract**

The object of the present invention is to provide an organic-inorganic hybrid material having heat resistance, and said object of the present invention can be attained by providing an organic-inorganic hybrid prepolymer containing a phenyl group which is prepared by the polycondensation reaction accompanying dehydration between a polydimethylsiloxane and a metal and/or semimetal alkoxide, wherein (a) phenyl group(s) is (are) partially or wholly introduced into said polydimethylsiloxane and/or said metal and/or semimetal alkoxide.

## Description

### FIELD OF THE INVENTION

The present invention relates to an organic-inorganic hybrid prepolymer containing a phenyl group which provides a heat-resistant organic-inorganic hybrid material, usable for a heat resistant elastic material and a sealant or the like for a high temperature heat generating element, and also relates to heat-resistant organic-inorganic hybrid material, and a sealing structure of an element or device.

### BACKGROUND OF THE INVENTION

Hitherto, a heat resistant material has been used as a film, or tape for the insulating or fixing material(s) of electronic or electric parts, or the like, or as a sealant for a semiconductor device, or as a wire bonding, or the like. A typical heat resistant material is a silicone resin. Said silicone resin is a well-known elastic material having both heat resistance and good safety, and furthermore, is low-priced. Recently, an organic-inorganic hybrid composite, having improved properties of said silicone resin, has been developed. Said organic-inorganic hybrid is prepared by introducing an inorganic component to said silicone resin.

Said organic-inorganic hybrid composite has both the properties of silicone resin as an organic component, such as flexibility, water-repellency, and release properties, or the like, and the properties of an inorganic component, such as heat resistance, heat conductivity, or the like (for instance, see Non-Patent Document 1). Said material has excellent properties such as heat resistance and flexibility at temperatures of 200°C or higher, and further, a high electric insulation strength, and low dielectricity at a high frequency range (Patent Document 1∼4).

### Prior Technical Documents

### Patent Documents

Patent Document 1: JPH01-113429
Patent Document 2: JPH02-182728
Patent Document 3: JPH04-227731
Patent Document 4: JP2009-292970
Patent Document 5: JP2009-164636
Patent Document 6: JP2009-024041
Patent Document 7: JP2004-128468
Patent Document 8: JP2010-118578
Patent Document 9: JP2010-010505
Patent Document 10: JP2004-107652
Patent Document 11: JP2005-320461

### NON-PATENT DOCUMENT

Non-Patent Document 1: G. Philipp and Schmidt, J. Non-Cryst. Solids 63,283 (1984)

### SUMMARY OF THE INVENTION

### PROBLEMS TO BE SOLVED BY THE INVENTION

As aforementioned, said organic-inorganic hybrid material has been used as the sealant for a semiconductor device, and wire bonding which are installed in the laser diode (LD), light emitting diode (LED), LED print head (LPH), charge coupled device (CCD), and the insulated gate bipolar transistor (IGBT), or the like.
Up to now, the Si semiconductor has been used as a semiconductor in said electronic parts, but recently the use of SiC semiconductor and GaN semiconductor is being investigated as alternatives to said Si semiconductor. Said SiC and GaN semiconductors are expected to be used as semiconductor devices being smaller in size, and consuming less electricity, and as power elements having high efficiency, and being high frequency elements, and as semiconductor devices having excellent anti-radioactivity properties. Therefore, said SiC and GaN semiconductors are in high demand in the fields of space development and atomic energy development, as well as in the held of electricity, transportation, and consumer electrical appliances. Recently, their use as semiconductors for hybrid cars is also being investigated.
For instance, the band gap of an SiC semiconductor is 3.25 eV, 3 times the band gap of an Si semiconductor in breadth, and the band gap of a GaN semiconductor is also 3 times that of an Si semiconductor in breadth, making the electric field strength against dielectric breakdown of these semiconductors 3 MV/cm, 10 times the electric field strength of an Si semiconductor. These semiconductors have excellent thermal conductivity, and heat-resisting properties, excellent chemical resistance, and further they also have higher anti-radioactivity properties than an Si semiconductor. For the aforementioned reasons, recently the IGBT and MOSFET have been partially replaced by the SiC or GaN semiconductors for inverter circuits and switching power sources, making a higher integration and a higher speed of operative processing practicable.
Nevertheless, since said SiC and GaN semiconductors generate a high temperature of about 200 to 250°C, in a case where a traditional organic-inorganic hybrid material is used as a sealant, the flexibility of said organic-inorganic hybrid material will decline due to the thermal deterioration of said organic-inorganic hybrid material. Said thermal deterioration of the sealant can bring about many problems such as destructive phenomena like the cracking and peeling of said sealant, and its loss of transparency and translucency.

### MEANS TO SOLVE SAID PROBLEMS

The object of the present invention is to solve said traditional problems by providing a heat resistant organic-inorganic hybrid material which can be used as the sealant of a device in which (an) SiC and/or GaN semiconductor(s) is (are) installed. Thus, the present invention provided herein relates to an organic-inorganic hybrid prepolymer containing a phenyl group which is prepared by the polycondensation reaction accompanying dehydration between a polydimethylsiloxane and a metal and/or semimetal alkoxide, wherein said phenyl group(s) is (are) partially or wholly introduced into said polydimethylsiloxane and/or said metal and/or semimetal alkoxide.
If desired, an oligomer of said metal and/or semimetal alkoxide may be used as said metal and/or semimetal alkoxide.
To put the present invention concretely, said polydimethylsiloxane into which said phenyl group(s) is (are) introduced is a polydimethylsiloxane containing phenyl group(s), indicated by the following general formula (Chemical Formula 1), and said metal and/or semimetal alkoxide into which said phenol group(s) is (are) introduced is an alkoxide containing said phenyl group(s) indicated by the following general formula (Chemical Formula 2): 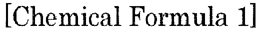 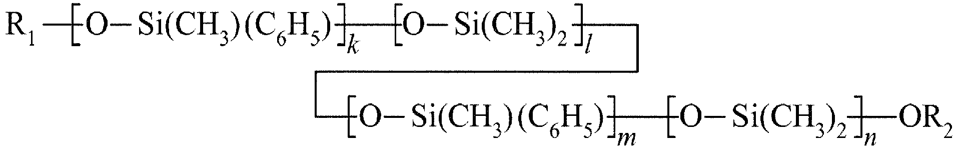 Said R₁ or R₂ is a straight chain or branch alkyl group having a carbon number of 1 to 4; R₁ and R₂ may each be of the same, or different alkyl groups, and k and 1 are integers between 1 and 10, and m and n are integers between 1 and 300. 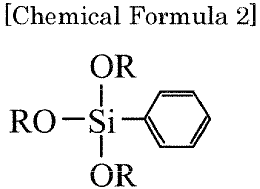 Said R is a straight chain or branch alkyl group having a carbon number of 1 to 4, and each R may be the same, partially different, or completely different. Further, the oligomer of said metal and/or semimetal alkoxide is an alkoxide oligomer indicated by the following general formula (Chemical Formula 3). 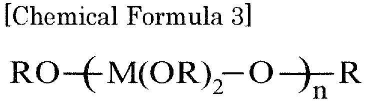 Said R is a straight chain or branch alkyl group having a carbon number of 1 to 4, and each R may be the same, or different, and n is an integer between 4 and 6.
Further, t-butanol and/or 2-ethoxyethanol is (are) preferably added as a stabilizing solvent to said organic-inorganic hybrid prepolymer.
In the present invention, a heat-resistant organic-inorganic hybrid material is further provided, and said heat resistant organic-inorganic hybrid material comprises a gelatinized material which is produced by heating and gelatinizing said organic-inorganic hybrid prepolymer containing a phenyl group.
Said heat resistant organic-inorganic hybrid material preferably has a hardness of 80 or less according to its measurement using a Shore E Hardness Meter, after being kept in an environment at 250°C for 1000 hours. Still further, in the present invention, a sealing structure for the element is provided, wherein said sealing structure for the element seals a heat-generating element, using heat resistant organic-inorganic hybrid material. In said sealing structure, for instance, SiC and/or GaN is (are) installed as the semiconductor(s).

### EFFECTS OF THE INVENTION

### [Actions]

In the present invention, a polydimethylsiloxane containing a phenyl group and/or metal and/or semimetal alkoxide containing a phenyl group are used as raw materials of the organic-inorganic hybrid prepolymer, wherein said polydimethylsiloxane containing a phenyl group and said metal and/or semimetal alkoxide containing a phenyl group is (are) prepared by introducing a phenyl group into said polydimethylsiloxane and/or said metal and/or semimetal alkoxide.
Said polydimethylsiloxane containing a phenyl group has the following structure.

### [Polydimethylsiloxane containing phenyl group]

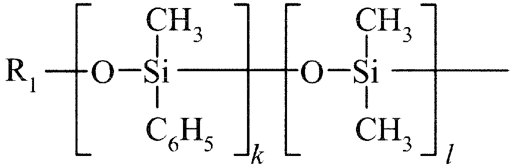

In said structure, the siloxane bonding (-Si-O-Si-) is hard to cut through heating since said phenyl group (C₆H₅-) has steric hindrance and electron attraction effects.

Said metal and/or semimetal alkoxide containing a phenyl group has the following structure.

### [Metal and/or semimetal alkoxide containing phenyl group]

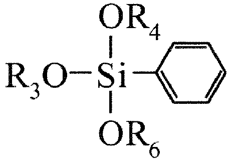

In said structure, the RO-s coordinated to Si's the second configuration positions are hard to be hydrolyzed by heat, since said phenyl group (C₆H₅-) has both steric hindrance and electron attraction effects.
Accordingly, in said organic-inorganic hybrid material of the present invention, the cutting of the main and side chains through heating is restricted by said phenyl group contained in said polydimethylsiloxane and/or said metal and/or semimetal alkoxide, making said organic-inorganic hybrid material difficult to be decomposed or degraded by heat, resulting in said organic-inorganic hybrid material having excellent thermal stability.

### [Effect]

Accordingly, said organic-inorganic hybrid material containing a phenyl group of the present invention, being a gelatinized material of said organic-inorganic hybrid prepolymer containing a phenyl group, has excellent heat-resisting properties so that said organic-inorganic hybrid material containing a phenyl group is exceedingly useful as a sealant for an element (device) into which SiC and/or GaN semiconductor(s) is (are) installed, since said SiC and GaN semiconductors generate a high temperature.

### BRIEF DESCRIPTION OF DRAWINGS

Fig.1 is a graph showing the results of the valuation of the heatresistant temperatures in the EXAMPLES of the present invention.
Fig.2 is a graph showing the results of the valuations of the hardness measurements in the EXAMPLES of the present invention.

### EMBODIMENTS TO PRACTICE THE INVENTION

### [DEFINITION]

### [SEMIMETAL]

The elements around the boundary between metallic elements and non-metallic elements in the periodic table, such as boron, silicon, germanium, arsenic, antimony, selenium, tellurium, or the like.

### [RATE OF DENATURING]

The rate of said oligomer introduced to the silanol group(s) positioned at one or both ends of the PDMS by a condensation reaction. For instance, a denaturing rate of 50% means that said oligomers have been introduced to 50% of the silanol group of the PDMS.

### [WEIGHT AVERAGE MOLECULAR WEIGHT]

The weight average molecular weight of the PDMS was measured by the gel permeation chromatography (GPC method), with polystyrene being used as a standard sample, and the conversion of the molecular weight by said polystyrene being measured.

### [Organic-inorganic hybrid prepolymer containing phenyl group]

The organic-inorganic hybrid prepolymer containing a phenyl group of the present invention (below abbreviated as a prepolymer containing a phenyl group) may generally include prepolymers in (1) to (5) to be described as follows.
Herein, "polydimethylsiloxane" is abbreviated as "PDMS", "polydimethylsiloxane containing a phenyl group" is abbreviated as "PDMS containing a phenyl group", "organic-inorganic hybrid prepolymer" is abbreviated as "prepolymer", "metal and/or semimetal alkoxide" is abbreviated as "alkoxide", "metal and/or semimetal alkoxide containing a phenyl group" is abbreviated as "alkoxide containing a phenyl group".
(1) Prepolymer 1, prepared by the polycondensation reaction accompanying the dehydration between a PDMS containing phenyl group and alkoxide.
(2) Prepolymer 11, prepared by the polycondensation reaction accompanying the dehydration between a PDMS containing a phenyl group, a PDMS not containing a phenyl group, and alkoxide not containing a phenyl group.
(3) Prepolymer 111, prepared by the polycondensation reaction accompanying the dehydration between a PDMS and alkoxide containing a phenyl group.
(4) Prepolymer Vl, prepared by the polycondensation reaction accompanying the dehydration between a PDMS containing a phenyl group and alkoxide containing a phenyl group.
(5) Prepolymer V, prepared by the polycondensation reaction accompanying the dehydration between a PDMS containing a phenyl group and a PDMS not containing a phenyl group, and alkoxide containing a phenyl group.
Said alkoxide and alkoxide containing phenyl group may be an oligomer in which a plural number (commonly 4 to 6) of alkoxides or alkoxides containing a phenyl group are combined together through polycondensation.
The raw materials used in said prepolymer containing a phenyl group of the present invention are described as follows.

### [POLYDIMETHYLSILOXANE (PDMS)]

The PDMS used in the present invention has silanol group(s) which can react with said metal and/or semimetal alkoxide on one or both ends. Said polydimethylsiloxane is indicated in the following general formulae.
(a) a PDMS having silanol groups on both ends 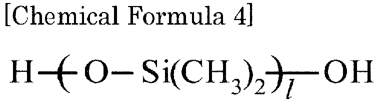
(b) a PDMS having a silanol group on one end 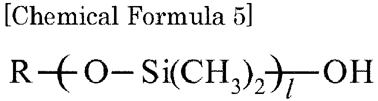 Wherein R in said chemical formula is an alkyl group and 1 is an integer of 50 or more.
   The weight average molecular weight of said PDMS used in the present invention is desirably in a range of 1,500 or more, and 100,000 or less.

### [PDMS containing phenyl group]

The PDMS containing a phenyl group to be used in the present invention includes the following condensation polymers:
a homo-condensation polymer of phenyl-methyl siloxane, wherein a methyl group of dimethylsiloxane is substituted by a phenyl group.
a co-condensation polymer of said phenyl-methyl siloxane and dimethyl siloxane.
A preferable PDMS containing a phenyl group is a block co-condensation polymer comprising said phenyl-methyl siloxane condensation polymer block and dimethylsiloxane condensation polymer block. Said block co-condensation polymer is indicated by the following general formula. 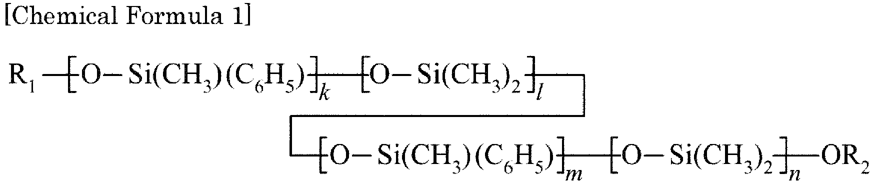 Wherein R₁ and R₂ in said formula each indicate a straight chain or branched alkyl group having a carbon number of between 1 and 4; R₁ and R₂ may each be of the same, or different alkyl groups, while k and 1 are each integers between 1 and 10, and further, m and n are each integers between 1 and 300.

### [METAL AND/OR SEMIMETALALKOXIDE]

The metal and/or semimetal alkoxide has the following general formula.

[Chemical Formula 6] **M(OR)₄**

Wherein M is a metal or semimetal, R is an alkyl group having a carbon number of 4 or less, and said 4 alkyl groups may be the same, partially different, or completely different.

As a metal and/or semimetal of said metal and/or semimetal alkoxide to be used in the present invention, silicone, boron, aluminum, titanium, vanadium, manganese, iron, cobalt, zinc, germanium, yttrium, zirconium, niobium, lanthanum, cerium, cadmium, tantalum, tungsten, or the like is (are) illustrated. Desirable metals or semi-metals may be silicone, titanium and zirconium.
Further, the kind of said alkoxide is not particularly limited, and said alkoxide may include such as methoxide, ethoxide n-propoxide, iso-propoxide, n-butoxide, iso-butoxide, sec-butoxide, tert-butoxide, methoxy-ethoxide, ethoxy-ethoxide or the like, and from the view point of stability and safety, ethoxide, propoxide, isopropoxide, or the like are desirable alkoxides.
As said metal and/or semimetal alkoxide, silicone alkoxide is a particularly desirable alkoxide, since said silicone alkoxide is easily procured, and stable in the air.
Said silicone alkoxide may include tetraalkoxy silane such as tetramethoxy silane, tetraethoxy silane, tetrapropoxy silane, tetraisopropoxy silane, tetrabutoxy silane or the like, trialkoxy silane such as methyltrimethoxy silane, methyltriethoxy silane, methyl tripropoxy silane, methyl tributoxy silane, ethyl trimethoxy silane, ethyltriethoxy silan, n-propyl trimethoxy silane, n-propyl triethoxy silane, isopropyl trimethoxy silane, isopropyl triethoxy silane, phenyl trimethoxy silane, phenyl triethoxy silane or the like. In said silicone alkoxides, tetraethoxy silane (TEOS), triethoxymethyl silane (TEOMS), tetra-propoxy silane, tetraisopropoxy silane, tetrabutoxy silane are desirable silicone alkoxides. Other desirable metal alkoxydes may be such as titanium tetraisopropoxide (TTP), zirconium teterapropoxide (ZTP) or the like.

### [Oligomer of metal and/or semimetal alkoxide]

The oligomer of said metal and/or semimetal alkoxide used in the present invention (below simply abbreviated as "oligomer") is a low molecular condensation polymer of said metal and/or semimetal alkoxide, and has the following general formula. 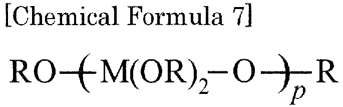 Wherein, M is a metal or semimetal; R is an alkyl group having a carbon number of 4 or less; said alkyl groups may be the same, partially different, or completely different, and n is an integer between 4 and 6.

Since said oligomer has a lower volatility and a lower density of the functional group (alkoxy group) than said metal and/or semimetal alkoxide monomer, said oligomer has a lower reactivity than said metal and/or semimetal alkoxide.

### [Metal and/or semimetal alkoxide containing phenyl group]

The metal and/or semimetal alkoxide containing a phenyl group is indicated by Chemical Formula 2, and is an alkoxide wherein an alkoxy group of 4 alkoxy groups of said alkoxide has been substituted by a phenyl group. 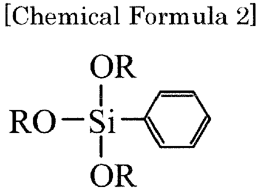 Wherein each R in said formula indicates a straight chain or branched alkyl group having a carbon number of 1 to 4, and said 3 alkyl groups may be the same, partially different, or completely different.

[Oligomer of metal and/or semimetal alkoxide containing phenyl group] The oligomer of said metal and/or semimetal alkoxide containing a phenyl group includes the following four types.

### (Oligomer 1)

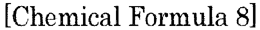

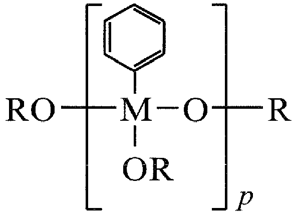

### (Oligomer 11)

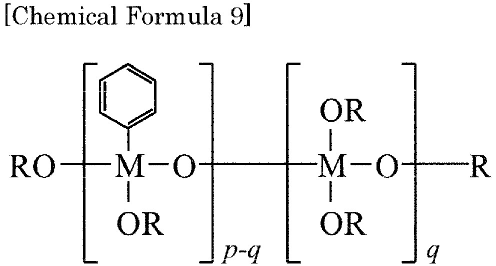

### (Oligomer 111)

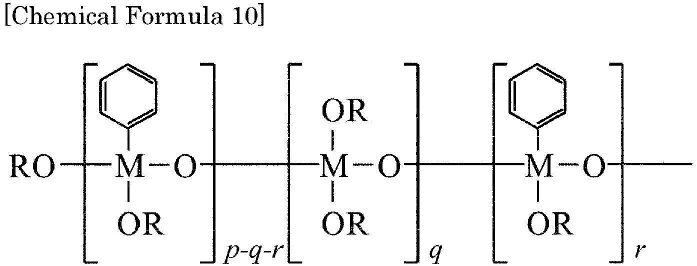

### (Oligomer IV)

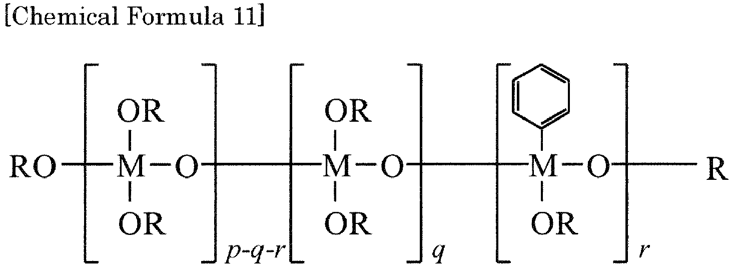

Wherein M is a metal or a semimetal; R is an alkyl group having a carbon number of 4 or less, and said alkyl groups may be the same, partially different, or completely different, with p being an integer between 4 and 6.

### [PREPARATION OF ORGANIC-INORGANIC HYBRID PREPOLYMER SOL]

In the present invention, said organic-inorganic hybrid prepolymer containing a phenyl group is prepared by the polycondensation reaction accompanying the dehydration between said PDMS containing a phenyl group or PDMS not containing a phenyl group (below abbreviated simply as (phenyl group containing) PDMS), and said alkoxide or oligomer containing a phenyl group or said alkoxide or oligomer not containing a phenyl group (below abbreviated simply as (phenyl group containing) alkoxide (oligomer)). In said polycondensation reaction accompanying the dehydration, the dehydration of an alkoxide group of said (phenyl group containing) alkoxide (oligomer) is accompanied.
In said polycondensation reaction accompanying the dehydration, commonly a condensation catalyst is used. Said condensation catalyst may include such as stannous octoate, dibutyltindilaurate, dibytyltindi-2-ethylhexoate, natrium-o-phenylphenate, tetra(2-ethylhexosil) titanate, or the like.
In a case where said polycondensation reaction accompanying the dehydration is carried out, in order to hydrolyze said (phenyl group containing) PDMS and said (phenyl group containing) alkoxide (oligomer) stably, a hydrolysis and condensation reaction are preferably carried out by heating in a reactor filled with an inert gas. Said inert gas may include nitrogen gas, and rare-gas which belongs to the group 18 elements such as helium, neon, argon, krypton, xenon, or the like. Two or more kinds of said gas may be used together.

Said organic-inorganic hybrid prepolymer containing a phenyl group is prepared by a polycondensation reaction accompanied with the hydrolysis of a mixture containing said (phenyl group containing) alkoxide (oligomer) and said (phenyl group containing) PDMS in the presence of said condensation catalyst in the reactor, the atmosphere in which has been substituted by said inert gas. Since said (phenyl group containing) alkoxide (oligomer) is easily hydrolyzed with water compared with said (phenyl group containing) PDMS, the alkoxy group of said (phenyl group containing) alkoxide (oligomer) changes to a highly reactive silanol group.
To be more precise, said hydrolyzed alkoxy group of said (phenyl group containing) alkoxide (oligomer) produces an -OH group, and the condensation reaction accompanying the dehydration between said -OH group of the resulting hydrolyzed (phenyl group containing) alkoxide (oligomer) and the silanol group at the end of said (phenyl group containing) PDMS is carried out by heating in the presence of said inert gas. In a case where said metal and/or semimetal alkoxide is provided as an oligomer, the single condensation reaction of said metal and/or semimetal alkoxide will not accelerate, so that the condensation reaction between the PDMS and the hydrolyzed oligomer can be smoothly carried out, to advance the condensation reaction favorably through the homogeneous reaction between said oligomer and said (phenyl group containing) PDMS.

Since the unnecessary hydrolysis reaction from the water existing in the air is suppressed by the hydrolysis reaction and the polycondensation reaction in the inert gas atmosphere, the condensation reaction between the silanol group of said (phenyl group containing) PDMS, which is an organic component, and the plural number of alkoxy groups of said (phenyl group containing) oligomer, which is an inorganic component, is promoted, to produce smoothly an organic-inorganic hybrid prepolymer as a sol.
Further, a low molecular weight siloxane, which exists in said (phenyl group containing) PDMS to cause deterioration of the organic-inorganic hybrid material, will be taken into the organic-inorganic hybrid prepolymer containing a phenyl group, or will volatilize during the condensation reaction through heating, and as a result, the amount of said low molecular weight siloxane remaining in said prepolymer as a simple substance will become extremely small, or non-existent.

As aforementioned, since no cluster which is an inorganic component, exists in said phenyl group containing organic-inorganic hybrid prepolymer sol, or said phenyl group containing organic-inorganic hybrid polymer (hardened material) produced by the gelation of said prepolymer sol, by using said organic-inorganic hybrid composite containing a phenyl group, heat-resistant adhesive materials, heat-resistant sealing materials, and heat conductive materials, having a higher quality than traditional ones, can be provided.

### [Rates of combination]

The rate of combination (A/B) of said (phenyl group containing) PDMS (A) and said (phenyl group containing) alkoxide or oligomer (B) is set to be at a 0.1 to 10 molar ratio, desirably a 0.5 to 1.5 molar ratio, more desirably a 0.8 to 1.2 molar ratio.
In a case where the molar ratio of A/B is beyond 10, the resulting sol may be unstable, and the resulting compound is apt to gelate, and the resulting gelated compound is apt to contract. On the other hand, in a case where the molar ratio of A/B is smaller than 0.1, the polycondensation reaction accompanying dehydration can not be smoothly carried out, making gelation difficult. As a result, a low molecular siloxane will remain in the compound.

### [Element (device) sealing structure]

The element (device) relating to the present invention may include an element mainly consisting of a semiconductor, or an element into which semiconductor(s) is (are) installed, or a device wherein semiconductor(s) is (are) installed on the upper side of said device's base panel. Said element (device) may include such as a transistor, diode, rectification element, negative resistance element, light electric generation element, light electric conduction element, luminous element, magnet electric element, operation element installed in a operation unit, or the like.
For instance, in the case of said light electric generation element, light electric conduction element, luminous element, or the like which emits or receives light (all together, they are said to be a light element), a light generating face or a light receiving face can be covered with this sealant for protection.
Further, in the case of the element(s) installed on the base panel, the terminal(s) of said element(s) is (are) electrically connected to the terminal(s) arranged on the surface of said base panel by wire bonding(s), and said wire bonding(s) can also be sealed together with said element(s) by said sealant.

### [Manufacturing method of element (device)]

The manufacturing method of the device, wherein said semiconductor element(s) is (are) installed on the base panel in the present invention, is described as follows. The case of a light element is herein adopted as an illustration.
In a case where said light element(s) is (are) installed on the base panel, said light element(s) is (are) installed onto the surface of said base panel by using an installing machine or the like available on the market. In a case where said light element(s) has (have) terminal(s) on the underside, no wire bonding may be needed, while in a case where said light element(s) has (have) terminal(s) on the surface, said terminal(s) of said light element(s) and the terminal(s) on the surface of said base panel are electrically connected together by wire bonding.
Following this, said sealant containing said phenyl group containing prepolymer of the present invention as its main component is coated at least onto the light emitting face, and/or receiving face of said light element(s), so as to seal said light element(s). In a case where said sealant is coated, attention should be paid so as not to mix any air bubbles into said sealant. Any method of coating said sealant can be applied, but commonly a coating machine which can quantitatively coat (seal) said sealant onto face(s) is preferably used. Said sealing can also be done so that the light element(s) is (are) wholly coated with said sealant.
Following this, said element(s) onto which said sealant has been coated is (are) put into a high temperature hearth (oven), and heated so as to gelatinize said sealant.
The resulting gelatinized sealant, being in its solid or semi-solid state, can then be molded into a desired shape.
Further, as a method to gelatinize said sealant, a method wherein an additive (hardener) is mixed into said sealant to gelatinize it without heating may be adopted.

Since a silicon resin, an organic-inorganic hybrid composite, and the like, which have been traditionally used as sealants, are apt to deteriorate over time, and become opaque or turn yellow, it is difficult to find foreign bodies which will stick to the surface of said sealants, and further, in a case where there are any faults within said sealants, any analysis of said fault (s) may be difficult.
On the other hand, said sealant comprising said organic-inorganic hybrid material containing a phenyl group of the present invention does not deteriorate over time and maintains its colorless and transparent state, so that if foreign bodies stick to the surface of said sealant, said foreign bodies can easily be found. Further, even if near ultraviolet light is irradiated onto said sealant for a long time, said sealant can maintain its transparency and translucency. Still further, even though said sealant is exposed to a high temperature environment, such as between 200 and 250°C, said sealant of the present invention will not bring about the destructive phenomena such as cracking, peeling, or the like due to the high temperature of heat generated from semiconductors such as SiC, GaN, or the like, so that problems such as the destruction of the element, breakage of the wire bonding, and deterioration of the insulation properties or the like do not occur in said sealant, so that the present invention can provide a semiconductor element (device) having high quality.

### EXAMPLES

The present invention is further concretely explained by the following EXAMPLE.
Wherein "part" and "%" in EXAMPLE are each expressed in mass standard, as "parts by mass" and "% by mass", unless a special description is added. Further, the preparation methods in which the rate of denaturing can be controlled are not limited by the methods described in EXAMPLE. For an evaluation of the rate of denaturing in EXAMPLE, a molecular weight measurement using SHODEX GPC-101 (made by Showadenko K.K.) is employed. The columns used in said molecular weight measurement are K-806M, and K-802.5 (SHODEX), which are connected.
Further, the present invention should not be limited by the EXAMPLE described hereafter.

### [EXAMPLE 1]

[Preparation of PDMS-TEPS organic-inorganic hybrid prepolymer A (Prepolymer 111)]
A reactor (a flask having a plural number of necks) was used, and a stirring device, a thermometer, and a dripping line were fitted to said flask. Using nitrogen gas as an inert gas, said nitrogen gas was sufficiently filled into said reactor.
The nitrogen gas used in EXAMPLE 1 was prepared by using nitrogen gas preparation equipment (made by JAPAN UNIX CO., Ltd. UNX-200).
A polydimethylsiloxane (made by Momentive Performance Materials Inc., XF3057, with an average molecular weight of 32000) as a PDMS, having (a) silanol group(s) at one or both ends, and containing no phenyl group, was then put into said reactor in which said nitrogen gas was sufficiently filled, and further, 2 mols of triethoxyphenyl silane (TEPS) (made by Tokyo Chemical Industry Co., Ltd.) as a phenyl group containing alkoxide was also put into said reactor to 1 mol of said PDMS. Still further, 0.1 mol of tetra (2-ethylhexyl) titanate (made by Matsumoto Fine Chemical Co., Ltd.) diluted at 5 times its volume by dehydrated ethanol (made by Wako Pure Chemical Industries, Ltd.) was then dripped into said reactor so as to promote the reaction, after which the resulting contents in said reactor were agitated for 30 minutes in a normal temperature (23 to 25°C) to prepare a raw material liquid A.
Further, as a stabilizing solvent for said raw material liquid A, 3 parts by weight (3 % by weight) of t-butanol for said PDMS was then dripped into said reactor in which nitrogen gas was filled, and the resulting contents were agitated for 30 minutes to prepare Prepolymer 1.

### [Preparation of prepolymer B (Prepolymer 11) using PDMS containing phenyl group]

A reactor (a flask having a plural number of necks) was used, and a stirring device, a thermometer, and a dripping line were fitted to said flask. Using nitrogen gas as an inert gas, said nitrogen gas was sufficiently filled into said reactor. The nitrogen gas then used was prepared by using nitrogen gas preparation equipment (made by JAPAN UNIX CO., LTD. UNX-200).
Next, 1 mole of a PDMS containing a phenyl group (made by Momentive Performance Materials Inc. YF3804, with an average molecular weight of 6000) was put into said reactor, following which 2 mols of ethyl silicate (made by Tama Chemicals Co., Ltd., Silicate 40 n=4 to 6, or Silicate 45 n=6 to 8), which was an oligomer (n=4 to 6) of tetraethoxysilane, and 1 mole of polydimethylsiloxane (made by Momentive Performance Materials Inc. YF3905, with an average molecular weight of 20,000) as a PDMS having (a) silanol group(s) at one or both ends and having no phenyl group, were put into said reactor, to promote the reaction and prepare a raw material solution B. Further, as a stabilizing solvent for said solution B, 3 parts by weight (3% by weight) of t-butanol for said PDMS was dripped into said reactor in which said nitrogen gas was filled, following which the contents in said reactor were then agitated for 30 minutes to prepare Prepolymer 2.

### [EVALUATION 1]

### (Sheet 1 for evaluation)

Said prepolymer (A) sol prepared in EXAMPLE 1, was poured into a mold (15 cm×15cm square) the surface of which was treated with a tetrafluoroethylene perfluoroalkylvinylether copolymer (PFA) so as to form a sheet having a finished thickness of 4 mm, following which said mold was heated, raising the temperature of said sol in said mold from 23°C (normal room temperature) to 250°C for 10 hours, following which said sol in said mold was kept for 2 hours for drying and firing processing. Following this, the resulting sheet was released from said mold to prepare a sheet 1 for evaluation (length 150mm× width 150mm×thickness 4mm).

### [(Sheet 2 for evaluation)

Said prepolymer (B) sol prepared in EXAMPLE 1, was poured into a mold (15 cm×15cm square) the surface of which was treated with PFA, so as to form a sheet having a finished thickness of 4 mm, following which said mold was heated, raising the temperature of said sol in said mold from 23°C (normal room temperature) to 250°C for 10 hours, following which said sol in said mold was kept for 2 hours for drying and firing processing. Following this the resulting sheet was released from said mold to prepare a sheet 2 for evaluation (length 150mm×width 150mm×thickness 4mm).

### [COMPARISON 1]

### (Traditional prepolymer)

First, 1.0 g of ethyl-silicate (made by Tama Chemicals Co., Ltd., Silicate 40, n=4 to 6 or Silicate 45, n=6 to 8) was put into a reactor onto which a stirring device, a thermometer, and a dripping line were fitted, and further, 32.0 g of a PDMS (mass average molecular weight: 32,000) (made by Arakawa Chemical Industries Ltd. HBSIL 039) both ends of which were denatured with an alkoxy group, was then put into said reactor, following which the contents of said reactor were agitated and mixed for about 30 minutes in a room temperature atmosphere, to prepare the raw material solution A, which is a mixture solution.
Following this, 0.93 g of water, the necessary amount for the hydrolysis and condensation processes of said raw material solution, was dripped into said reactor for about 1 hour, and the contents of said reactor were then agitated and mixed.
Following this, the contents of in said reactor were naturally cooled for about 30 minutes to room temperature as said contents being agitated, to prepare a traditional prepolymer sol.

Said traditional prepolymer sol prepared for comparison, was then poured into a mold (15 cm×15cm square) the surface of which was treated with PFA, so as to form a sheet having a finished thickness of 4mm, following which said mold was heated, raising the temperature of said sol from 23°C (normal room temperature) to 250°C for 10 hours, following which said sol in said mold was kept for 2 hours for drying and firing processing. Following this, the resulting sheet was released from said mold, to prepare a sheet 1 for comparison (length 150mm×width 150mm×thickness 4mm).

### [EVALUATION METHODE]

### (Heatresistant temperature evaluation)

The heatresistant temperature was measured as follows.
Said sheets for evaluation and said sheet for comparison were each kept in a convection type drying furnace at an atmospheric temperature of 250°C, following which the weight of each sheet was measured separately by using an electronic balance [made by Mettler-Toledo International Inc., New Classic MF (Model:ML204)] at fixed intervals until 500 hours elapsed, following which each sheet's rate of weight reduction from its original weight was calculated by using the following formula, [the rate of change in weight =((the original weight - the weight after every fixed interval)/the original weight) ×100].

### [HARDNESS MEASUREMENT EVALUATION]

The hardness measurement evaluation was carried out by measuring the hardness of said sheets for evaluation and said sheet for comparison at fixed intervals, each of said sheets being kept in a convection type drying furnace at an atmospheric temperature of 250°C, by using a type E durometer for soft type rubber (having a low hardness) provided by JIS K 6253, ISO 7619.

### [RESULTS OF EVALUATIONS]

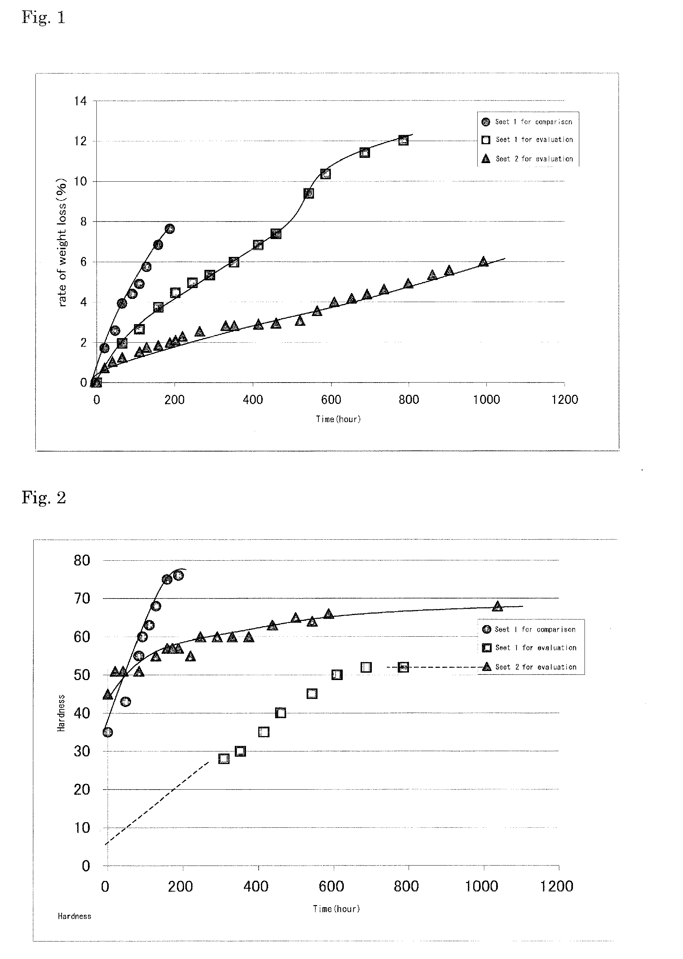

The results of the heatresistant temperature evaluations are shown in Fig. 1. Referring to Fig. 1, when comparing said sheets 1 and 2 for evaluation, said sheets both comprising said hybrid material of the present invention, and sheet 1 for comparison comprising the traditional hybrid composite (comparison sheet 1 in Figure), it is recognized that in the case of said sheet 1 for comparison comprising the traditional hybrid composite, the weight of said sheet 1 decreased in a short time at an atmospheric temperature of 250°C, cracking (breakage) of said sheet occurring in 200 hours, and that, on the other hand, sheet 1 for evaluation comprising said hybrid material of the present invention displayed a comparatively slow rate of weight reduction even at an atmospheric temperature of 250°C, showing that said sheet maintained a long heat resistance property for 500 hours or more, and that sheet 2 for evaluation also displayed comparatively slow rate of weight reduction even at an atmospheric temperature of 250°C, showing that said sheet also maintained excellent heat stability, particularly displayed by a weight reduction rate of 4% or less, after the passage of 500 hours.
It is recognized that said hybrid material of the present invention has improved reactivity due to the introduction of a phenyl group, to obtain a hardening material having few unreacted parts, and that said hybrid material also has an improved heat resistance property through thermal stability of the phenyl group in the molecules. In other words, it is recognized that sheet 1 for evaluation provides a hardening material having a low hardness, and so being soft by the stabilizing action of the phenyl group originating in an said phenyl group containing alkoxide, and that sheet 2 for evaluation provides a hardening material having a high level of hardness and heat stability due to the stabilizing action of the phenyl group originating in said PDMS, containing said phenyl group.

The results of the hardness measurement evaluation are shown in Fig. 2. Referring to Fig. 2, it is recognized that when comparing said sheets for evaluation, said sheets both comprising said hybrid material of the present invention, and sheet 1 for comparison comprising the traditional hybrid composite (comparison sheet 1 in Figure), in the case of comparison sheet 1, a polycondensation reaction on the surface of said sheet was promoted at an atmospheric temperature of 250°C, increasing the hardness of said sheet in a short time, and resulting in the outbreak of cracking (breakage) after 200 hours. Further, regarding sheet 1 for comparison, in a case where hardness measurements were continued after the passage of 200 hours, the hardness value was beyond the limits at which hardness could be measured with the type E durometer, in other words, the hardness results measured with said Shore E hardness tester were beyond 80 after the passage of 437 hours.
In the case of sheet 1 for evaluation comprising said hybrid material of the present invention, said sheet had a hardness even at an atmospheric temperature of 250°C in the range in which said hybrid material was of practical use, said hardness being the same as the hardness that said sheet for comparison had at a temperature of 80°C or below, being the upper limit at which said sheet for comparison fitted for use, further, in the case of sheet 2 for evaluation comprising said hybrid material of the present invention, said sheet displayed no hardness changes at an atmospheric temperature of 250°C, with any changes in the hardness of said sheet after the passage of 500 hours amounting to only about +10°. Still further, in the case of sheet 1 for evaluation, the hardness of said sheet remained 60 or less without any change after the passage of 700 hours at an atmospheric temperature of 250°C, and in the case of sheet 2, the hardness of said sheet remained 70 or less without any change after the passage of 500 hours at an atmospheric temperature of 250°C.
As a result, it is recognized that in the case of said hybrid material of the present invention, the reactivity of said hybrid material is improved by the introduction of a phenyl group, to obtain a hardening material having a few unreacted parts, and that heat resistance of said hardening material is improved due to the heat stability of the phenyl group in the molecules of said hybrid material.
That is to say, said, sheet 1 for evaluation comprising said hybrid material of the present invention has long term thermal stability, and can maintain a low hardness for 500 hours or more at an atmospheric temperature of 250°C, and can maintain a low hardness of 60 or less after the passage of 1000 hours at an atmospheric temperature of 250°C. Further, said sheet 2 for evaluation comprising said hybrid material of the present invention displays few changes in hardness after being kept for 500 hours at an atmospheric temperature of 250°C, and maintains a low hardness of 70 or less after the passage of 1000 hours at an atmospheric temperature of 250°C. Still further said sheet 2 has excellent thermal stability, shows little thermolysis, and does not generate an abnormal amount of heat through thermolysis. This means that in the case of sheet 2, no drastic decomposition, volatilization, or heat generation or the like will break out due to thermolysis, so that it can be said that said hybrid material of the present invention has useful properties for a heat resistant material.

As aforementioned, it is recognized that said hybrid material of the present invention has superior properties to said traditional hybrid composite in the two aforementioned items evaluated above.
Further, it is recognized that no inferiorities such as cracking (breakage) or the like may occur in said hybrid material of the present invention, after the passage of 1,000 hours at an atmospheric temperature of 250°C, and that the hardness of said hybrid material of the present invention measured with the Shore E hardness tester, is desirably 80 or less, more desirably 75 or less, and further more desirably 70 or less.

### [ALTERATION]

The present invention should not be limited only by aforementioned EXAMPLE, and alterations, deletions, and additions can be made so far as they don't contradict the technical idea of the present invention which can be recognized by any person skilled in the art from the descriptions of Claims and Specification.

For instance, the use of different kinds of metal and/or semimetal alkoxide having different properties from said metal and/or semimetal alkoxide described in EXAMPLE may not be limited by the description in EXAMPLE.

Further, a PDMS having a different molecular weight distribution may be used. For instance, in a case where a PDMS having a narrow molecular weight distribution and so a uniform molecular weight is used, a hybrid composite having very few unreacted parts can be obtained, and such a hybrid composite will have superior hardness and water-repellent properties of the surface.

In the aforementioned EXAMPLE, since said organic-inorganic hybrid prepolymer is in a sol state, in order to prepare a molded article in a solid or semi solid state (gel) by firing, said organic-inorganic hybrid prepolymer sol is coated onto a tray, such as a mold having a tray shape, following which said prepolymer sol in said tray is then treated by drying and firing in order to be hardened (gelated). The shape of said molded article is not especially limited, said molded article generally having a sheet or panel shape.

Further, the purity of said inert gas used to replace the air in the reactor may be 80% or more, and the water content of said inert gas may be 20% or less.

In a case where said organic-inorganic hybrid material is used as a heat resistant elastic material, a ceramic filler may be combined therein so as to provide heat conductivity, and a scale shaped insulating filler may be combined so as to provide electrical insulating properties.
Further, in the case of an optical use, wherein a transparent material is required, only said sol may be hardened without the combination of a filler. In the case of an adhesive use, said sol may be provided in a semi-hardened state so as to be hardened by the heat treatment during use.
By using the synthesis method of the present invention, the denaturing rate of said organic-inorganic hybrid material can be set according to the material's intended use, such as for a sealant, adhesive, heat conductive sheet, insulating sheet, interlaminar insulating membrane, or the like, so that a hybrid prepolymer sol being suitable for its specific purpose of usage can be provided.

As the application techniques of said organic-inorganic hybrid prepolymer of the present invention, said prepolymer can be adopted for use as an adhesive, paint, or the like, in addition to being useful as a sealant.
The hardening material (gelling material) of said organic-inorganic prepolymer sol of the present invention has an elastic property at high temperatures, and said material also has an excellent heat expansion relaxation ability for the materials to be bonded through the thermal shock. Accordingly, said hardening material can be used as an adhesive layer to relax heat stress by providing interference between different materials to be bonded.
Further, as the application techniques of said organic-inorganic hybrid prepolymer, said prepolymer can be adopted for use as a sealant, potting material or the like, which are adopted for use as a semi conductive element, such as a luminescent element like a laser diode, or the like, and such as a light receiving element like an image sensor, or the like.

### POSSIBILITY OF THE INDUSTRIAL USE

Said organic-inorganic hybrid prepolymer containing a phenyl group provides a gelatinized material having heat resistance, and said gelatinized material is useful as a sealant or adhesive for heat generating elements, a film or tape used for insulating, or for fixing in electronic and electric parts, making the present invention industrially usable.

## Claims

1. An organic-inorganic hybrid prepolymer containing a phenyl group which is prepared by the polycondensation reaction accompanying dehydration between a polydimethylsiloxane and a metal and/or semimetal alkoxide, wherein said phenyl group(s) is (are) partially or wholly introduced into said polydimethylsiloxane and/or said metal and/or semimetal alkoxide.

2. An organic-inorganic hybrid prepolymer containing a phenyl group in accordance with Claim 1, wherein a metal and/or semimetal alkoxide oligomer is used as said metal and/or semimetal alkoxide.

3. An organic-inorganic hybrid prepolymer containing a phenyl group in accordance with Claim 1 or 2, wherein said polydimethylsiloxane into which said phenyl group(s) is (are) introduced is a polydimethylsiloxane containing a phenyl group indicated by the following general formula: 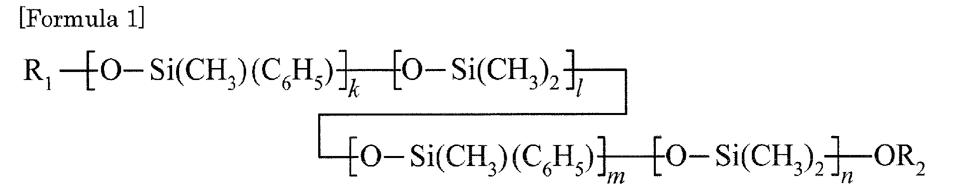 wherein R₁ and R₂ in said formula each indicate a straight chain or branched alkyl group having a carbon number of 1 to 4; R₁ and R₂ may each be of the same or different alkyl groups, with k and 1 being integers between 1 and 10, and further, m and n each being integers between 1 and 300.

4. An organic-inorganic hybrid prepolymer containing a phenyl group in accordance with any of Claims 1 to 3, wherein said metal and/or semimetal alkoxide into which said phenyl group(s) is (are) introduced is an alkoxide containing a phenyl group indicated by the following general formula: 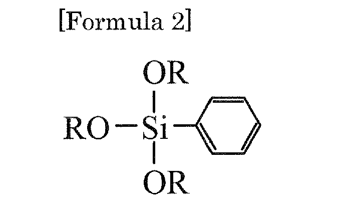 wherein each R in said formula indicates a straight chain or branched alkyl group having a carbon number of 1 to 4, with each R being the same or partially different, or completely different.

5. An or ganic-inorganic hybrid prepolymer containing a phenyl group in accordance with any of Claim 2 to 4, wherein said metal and/or semimetal alkoxide oligomer is an alkoxide oligomer indicated by the following general formula: 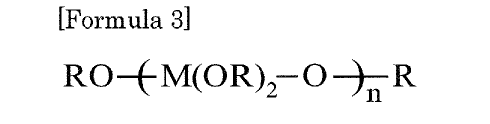 wherein each R in said formula indicates a straight chain or branched alkyl group having a carbon number of 1 to 4, with each R being the same or different, and further, n being an integer between 4 and 6.

6. An organic-inorganic hybrid prepolymer containing a phenyl group in accordance with any of Claims 1 to 5, wherein t-butanol and/or 2-ethoxyethanol is (are) added to said organic-inorganic hybrid prepolymer containing a phenyl group as (a) stabilizing solvent(s).

7. A heat-resistant organic-inorganic hybrid material comprising a gelatinized material which is produced by heating and gelatinizing said organic-inorganic hybrid prepolymer containing a phenyl group in accordance with any of Claims 1 to 6.

8. A heat-resistant organic-inorganic hybrid material in accordance with Claim 7, wherein said heat-resistant organic-inorganic material has a hardness of 80 or less according to its measurement using a Shore E hardness meter, after being kept in an environment at 250°C for 1000 hours.

9. A sealing structure of an element **characterized by** sealing a heat-generating element using said heat resistant organic-inorganic hybrid material in accordance with Claim 7 or 8.

10. A sealing structure of an element in accordance with Claim 9, wherein SiC and/or GaN is (are) installed as the semiconductor(s) in said heat-generating element.
